Europäisches Patentamt

(19) European Patent Office

Office européen des brevets

(11) EP 0 565 403 B1

(12) FASCICULE DE BREVET EUROPEEN

(45) Date de publication et mention
de la délivrance du brevet:
08.10.1997 Bulletin 1997/41

(51) Int. Cl.⁶: **C01B 33/145**, G03C 9/08,
G03F 7/075

(21) Numéro de dépôt: 93400805.3

(22) Date de dépôt: 29.03.1993

(54) **Dispersions silico-acryliques, leur procédé d'obtention, leur application en stéréophotolithographie et procédé de préparation d'objets en résine**

Kieselsäure/Acrylesterdispersionen, Verfahren zu deren Herstellung, ihre Verwendung in Stereophotolithographie und Herstellungsverfahren von Gegenständen aus Harz

Silica/acrylation dispersions, method for producing them, their use in stereophotolithography and method for preparing articles made of resin

(84) Etats contractants désignés:
BE CH DE DK GB IT LI NL SE

(30) Priorité: 08.04.1992 FR 9204297

(43) Date de publication de la demande:
13.10.1993 Bulletin 1993/41

(73) Titulaire: SOCIETE FRANCAISE HOECHST
92800 Puteaux (FR)

(72) Inventeurs:
• Darrou, Arnaud
F-54320 Neuves Maisons (FR)
• Corbel, Serge
F-54600 Villers-les-Nancy (FR)

• Andre, Jean-Claude
F-54000 Nancy (FR)
• Jacquinot, Eric
F-60350 Attichy (FR)
• Eranian, Armand
F-92310 Sevres (FR)

(74) Mandataire: Rinuy, Santarelli
14, avenue de la Grande Armée
75017 Paris (FR)

(56) Documents cités:
EP-A- 0 220 026          EP-A- 0 393 673
EP-A- 0 460 560

## Description

La présente invention concerne des dispersions silico-acryliques, leur procédé d'obtention, leur application en stéréophotolithographie et un procédé de préparation d'objets en résine.

La stéréophotolithographie est actuellement de plus en plus utilisée pour fabriquer des pièces complexes de petites dimensions, à partir de résines photosensibles. Les résines actuellement disponibles sur le marché pour cette technique, ne permettent pas encore d'obtenir des objets répondant à toutes les exigences de l'utilisateur qui souhaite disposer, à faible prix, d'objets fiables, de bonne présentation, possédant d'excellentes propriétés mécaniques et un vieillissement correct.

Afin de répondre à cette demande, la demanderesse a découvert avec étonnement que certaines dispersions de silice colloïdale présentent d'excellentes propriétés applicatives en stéréophotolithographie.

Le document EP-A-0 220 026 décrit un sol d'oxyde durci par irradiation telle que rayons U.V., électrons, $\gamma$, X, par chauffage ou par utilisation d'un catalyseur. Le sol d'oxyde ne comprend pas moins de 20% en poids d'un oxyde tel que $SiO_2$ ou $Al_2O_3$ dans un milieu de dispersion contenant au moins 80% en mole de monomère réactif tel que l'acide acrylique et ses esters. Il décrit aussi leur utilisation comme agent modifiant des résines, liants pour céramiques, agents épaississants pour cosmétiques, agents de couchage pour papier et agents antistatiques pour tissus.

Le document EP-A-460 560 décrit un sol de silice polymérisable dans lequel au moins un monomère contient une double liaison avec soit un groupement OH, soit une structure adamantane et son application en optique.

On connaît déjà des dispersions de silice colloïdale dans l'acrylate d'hydroxy-2 éthyle, mais à la connaissance de la demanderesse, ces dispersions de silice, d'une part sont monodisperses c'est à dire que les particules de silice dispersées présentent sensiblement toutes un même diamètre moyen, et d'autre part elles contiennent pondéralement moins de 50% de silice. Ces dispersions sont aisément obtenues en mélangeant, à la température ambiante, un hydrosol de silice monodisperse, sous forme acide, contenant moins de 50% en poids de silice colloïdale, dont les particules discrètes de silice, non liées entre elles par des liaisons siloxane, présentent un diamètre moyen identique compris entre 10 et 50 nm, avec de l'acrylate d'hydroxy-2 éthyle, puis en éliminant l'eau de ce mélange, habituellement par distillation azéotropique sous pression réduite, jusqu'à l'obtention d'un organosol de silice pratiquement exempt d'eau et contenant pondéralement moins de 50% de silice.

C'est pourquoi la présente invention a pour objet des dispersions de silice colloïdale dans un acrylate d'alcanol, ou un mélange d'acrylates d'alcanols, de formule générale (I).

$$CH_2 = CH - COO - CHR - CHOH - R_1 \qquad (I)$$

dans laquelle soit R et $R_1$, identiques, représentent un atome d'hydrogène, soit R et $R_1$, différents, représentent, un atome d'hydrogène ou un radical méthyle, caractérisées par le fait qu'elles contiennent pondéralement de 50 à 70% de silice à l'état de particules discrètes, polydisperses, c'est à dire appartenant à au moins deux groupes de silice monodisperse, non liées entre elles par des liaisons siloxane d'un diamètre moyen compris entre 10 et 50 nm.

Par "polydisperses", l'on entend que l'étude de la dispersion des particules indique l'existence de plusieurs pics, correspondant donc à plusieurs diamètres moyens.

Parmi ces dispersions, l'invention a notamment pour objet des dispersions caractérisées par le fait que 20 à 50% en poids de la silice présente est sous forme de particules discrètes, d'un diamètre moyen identique, inférieur ou égal à la moitié du diamètre moyen d'au moins 50% en poids des particules de silice restantes.

Parmi ces dernières dispersions, l'invention a notamment pour objet une dispersion de silice colloïdale dispersée dans de l'acrylate d'hydroxy-2 éthyle contenant pondéralement de 50 à 70 % de silice à l'état de particules discrètes non liées entre elles par des liaisons siloxane, présentant pour 40 à 50 % en poids d'entre elles un diamètre moyen d'environ 13 nm, et pour le complément à 100 %, un diamètre moyen d'environ de 50 nm.

Les acrylates d'alcanols de formule générale (I) sont soit, et de préférence l'acrylate d'hydroxy-2 éthyle, soit un mélange en proportions variables des monoesters de l'acide acrylique avec le propanediol-1,2. Ces monomères sont connus et ils sont commercialisés stabilisés avec de 0,1 à 0,01 % en poids d'un stabilisant tel que le paraméthoxyphénol. Ce stabilisant est conservé dans les dispersions de la présente invention, en cas d'utilisation des tels produits

L'invention a tout particulièrement pour objet les dispersions de silice colloïdale décrites dans les exemples.

La présente demande a aussi pour objet un procédé de préparation des dispersions ci-dessus, caractérisé par le fait que l'on mélange, sous agitation, à la température ambiante, un hydrosol de silice, monodisperse, sous forme acide, contenant pondéralement 30 à 50 % de silice à l'état de particules discrètes non liées entre elles par des liaisons siloxane, d'un diamètre moyen de 10 à 50 nm avec une quantité calculée d'un acrylate d'alcanol ou d'un mélange d'acrylate d'alcanol de formule générale (I) ci-dessus de manière à obtenir le taux de silice désiré compris entre 50 et 70 % en poids, puis que l'on distille l'eau présente dans cette dispersion, à une température inférieure à 55°C, sous pression réduite et sous agitation, jusqu'à un taux d'eau résiduelle inférieur à 1 % en poids, déterminé par la méthode de Karl Fischer, pour obtenir une dispersion monodisperse de silice colloïdale dans l'acrylate d'alcanol, ou le mélange d'acrylates d'alcanols de formule générale (I) choisi, contenant de 50 à 70 % en poids de silice sous forme de particules discrètes non liées entre elles par des liaisons siloxane, présentant un diamètre moyen de 10 à 50 nm que l'on isole ou, si désiré l'on mélange, à la température ambiante, dans des proportions convenables, avec une ou plusieurs autres dispersions monodisperses de silice colloïdale de granulométrie souhaitée et de taux de silice adéquat, dans un acrylate d'alcanol, ou un mélange d'acrylates d'alcanols de formule générale (I) identique et préparées selon le procédé décrit ci-dessus, de manière à obtenir la dispersion silicoacrylique polydisperse souhaitée.

La présente demande a notamment pour objet le procédé ci-dessus caractérisé par le fait que l'on prépare une dispersion monodisperse de particules de silice colloïdale d'un certain diamètre que l'on mélange avec au moins une dispersion monodisperse de particules de silice colloïdale d'un diamètre moyen inférieur ou égal à la moitié du diamètre moyen des premières particules de silice, les dernières particules de silice représentant 20 à 50 % en poids de la silice présente, tandis que les premières particules de silice représentent au moins 50 % des particules de silice restantes.

Elle a particulièrement pour objet le procédé ci-dessus caractérisé par le fait que 40 à 50 % en poids des particules de silice ont un diamètre moyen d'environ 13 nm, et le complément à 100 % a un diamètre moyen d'environ 50 nm.

Ainsi, pour obtenir une dispersion selon la présente invention contenant de l'acrylate d'hydroxy-2 éthyle, 62,5 % de silice à l'état de particules discrètes présentant pour 48 % en poids d'entre elles, un diamètre moyen de 13 nm et pour le complément à 100 %, un diamètre moyen de 50 nm, on mélange, à la température ambiante, des quantités identiques d'une dispersion de silice colloïdale monodisperse dans l'acrylate d'hydroxy-2 éthyle contenant 60 % en poids de silice à l'état de particules d'un diamètre moyen de 13 nm et d'une dispersion de silice colloïdale monodisperse dans l'acrylate d'hydroxy-2 éthyle contenant 65 % en poids de silice à l'état de particules d'un diamètre moyen de 50 nm.

La présente invention a aussi pour objet des dispersions de silice colloïdale obtenues par les procédés ci-dessus.

Les hydrosols de silice, monodisperses, sous forme acide, sont obtenus par des procédés connus, notamment par lixiviation de l'hydrosol de silice correspondant commercial stabilisé par un agent alcalin, tel que l'ammoniaque ou un hydroxyde de métal alcalin sur un lit de résine échangeuse de cations sous forme acide. On peut citer par exemple ceux commercialisés sous les noms de KLEBOSOL [R] par la Société Française Hoechst.

Les dispersions silico-acryliques selon la présente invention peuvent être, soit diluées en toutes proportions avec un acrylate d'alcanol de formule générale (I), pour diminuer, si désiré, leur concentration en silice, soit concentrées sous pression réduite et sous agitation, à une température inférieure à 55°C, pour élever, si désiré, leur concentration en silice jusqu'à 70 % en poids.

Le taux de silice des dispersions silico-acryliques selon la présente invention, est déterminé par calcination d'un échantillon de poids connu. Quant à la granulométrie, elle peut être déterminée par microscopie électronique en transmission ou, indirectement, par adsorption d'azote après séchage de la dispersion selon S. Brunauer et al., J.Amer, Chem. Soc., 60, 309 (1938).

Les dispersions silico-acryliques selon la présente invention présentent d'intéressantes propriétés en stéréophotolithographie.

Pour leur application en stéréophotolithographie, on introduit par exemple dans les dispersions selon la présente invention, jusqu'à 5 % en poids d'un ou plusieurs amorceurs de polymérisation photosensibles désignés couramment photoamorceurs, tel qu'un dérivé d'une cétone aromatique substituée comme la benzophénone, l'hydroxy-1 cyclohexylphénylcétone, la méthyl-2 morpholino-2 paraméthylthiopropiophénone. On peut également introduire divers additifs classiques pour ce type d'application, tels qu'un inhibiteur de polymérisation comme le paraméthoxyphénol, l'hydroquinone, un co-amorceur, un dispersant, des colorants et/ou des pigments. Généralement, le poids total des additifs introduits est inférieur à 10% en poids de la dispersion. Avantageusement, dans les dispersions selon la présente invention destinées à la stéréophotolithographie, on complète le taux d'un ou plusieurs inhibiteurs de polymérisation radicalaire tels que le paraméthoxyphénol ou l'hydroquinone, jusqu'à 2 % en poids, on évite ainsi des polymérisations parasites, et notamment, celles induites par la lumière diffusée par les particules de silice lors de leur irradiation à l'aide d'un faisceau laser actif.

Il est également possible de remplacer, partiellement ou totalement, le ou les amorceurs de polymérisation photosensibles par un ou plusieurs amorceurs de polymérisation thermiques tels que le peroxyde de benzoyle lorsque l'on utilise un laser thermique du type $CO_2$ en SPL.

Le ou les amorceurs photosensibles ou thermiques utilisés, ainsi que les divers additifs, sont généralement introduits dans les dispersions selon la présente invention, juste avant leur utilisation en stéréophotolithographie. Toutefois, il est avantageux qu'un ou plusieurs inhibiteurs de polymérisation radicalaire tels que le paraméthoxyphénol, ou l'hydroquinone soient présents au cours de leur préparation.

En stéréophotolithographie, les dispersions selon la présente invention présentent d'intéressantes propriétés, et notamment elles conduisent pendant et après la polymérisation induite avec un faisceau laser, à de très faibles retraits volumiques.

On définit le retrait volumique par la relation (1) :

$$r\% = 100 \frac{dp - dm}{dm} \qquad (1)$$

dans laquelle dm et dp représentent respectivement la masse volumique du monomère et du monomère polymérisé. Ces masses volumiques sont déterminées par les méthodes classiques.

Pour connaître et étudier le retrait en cours de la polymérisation, on dépose sur une coupelle suspendue avec des fils à un plateau d'une balance de précision, une fine couche d'une dispersion selon la présente invention, contenant 2 % en poids de méthyl-2 morpholino-2 paraméthylthiopropiophénone. Après avoir noté la masse de l'échantillon, on immerge complètement la coupelle dans de l'huile de paraffine de densité 0,86. La différence des masses de l'échantillon dans l'air et dans l'huile de paraffine permet de connaître son volume. L'échantillon au sein de l'huile de paraffine est alors irradié avec un faisceau lumineux UV, il polymérise lentement. La masse de l'échantillon dans l'huile de paraffine varie en fonction de la variation de son volume au cours de la polymérisation. Parallèlement, on effectue la même expérience en l'absence de monomère et on retranche les valeurs obtenues des valeurs expérimentales trouvées avec l'échantillon.

Toutes les minutes, on calcule à l'aide de la relation (1) le retrait volumique, puis on construit le graphe du retrait volumique ainsi calculé en fonction du temps de polymérisation. On constate ainsi qu'avec les dispersions selon la présente invention, le retrait est nul en début de polymérisation, puis il croît régulièrement en fonction du temps, jusqu'à une valeur limite identique à la valeur trouvée directement sur le polymère par application de la relation (1).

Les dispersions selon la présente invention présentent également un bonne profondeur de polymérisation. Cette caractéristique est un facteur important pour l'obtention d'objets en stéréophotolithographie, car une profondeur de polymérisation trop faible ne permet pas un accrochage satisfaisant des couches. Par ailleurs, de par leurs bonnes propriétés de transparence, les dispersions selon l'invention diffusent peu de lumière active, ce qui entraîne une bonne résolution spatiale.

Pour déterminer la profondeur de polymérisation, on place dans une cuve pour spectrophotomètre UV, de section 1 cm$^2$, l'échantillon de la dispersion à tester contenant 1 % en poids d'IRGATURE $^R$ 500 qui est un mélange équipondéral de benzophénone et d'hydroxy-1 cyclohexylphénylcétone, puis l'échantillon est irradié ponctuellement avec un rayon laser pendant une durée déterminée (1 minute pour un laser d'une puissance de 100 mW). On vide ensuite la cuve, on lave à l'acétone le polymère obtenu, puis on mesure la hauteur du pic du polymère formé au point d'impact du rayon laser. Pour les différentes dispersions selon la présente invention, les hauteurs des pics mesurées varient de 4 à 7 mm, correspondant à une très bonne profondeur de polymérisation.

Les dispersions selon la présente invention présentent aussi une viscosité satisfaisante pour réaliser sans problème des objets de forme complexe en stéréophotolithographie.

Les exemples suivants illustrent la présente invention sans toutefois la limiter.

## EXEMPLE 1

On mélange à la température ambiante, sous agitation, 8000 g d'un hydrosol de silice commercialisé sous le nom de KLEBOSOL $^R$ 1344 Na par la Société Française Hoechst présentant un pH de 9,7 et contenant pondéralement 69,6 % d'eau, 0,4 % de $Na_2O$ et 30 % de silice à l'état de particules monodisperses, non liées entre elles par des liaisons siloxane et présentant un diamètre moyen de 13 nm avec 708 g (0,9 l) d'une résine échangeuse de cations à groupements sulfoniques sous forme acide et d'une capacité d'échange de 2 eq/l. Après une heure d'agitation, la résine est séparée du milieu réactionnel par filtration. On obtient ainsi environ 8000g d'un hydrosol de silice acide présentant un pH = 2, et contenant pondéralement environ 70 % d'eau et 30 % de silice à l'état de particules monodisperses d'un diamètre moyen de 13 nm.

On mélange, sous agitation, à la température ambiante, 4130,2 g de l'hydrosol de silice acide préparé ci-dessus avec 851,3 g d'acrylate d'hydroxy-2 éthyle commercial et 17,2 g d'hydroquinone. Puis, l'eau présente dans le milieu réactionnel est distillée sous agitation, à une température inférieure à 55°C, sous une pression réduite progressivement de 60 à 20 mbar. On obtient ainsi 2110 g d'un organosol de silice contenant pondéralement 38,4 % d'acrylate d'hydroxy-2 éthyle, 0,6 % d'eau déterminée par la méthode de Karl Fischer, 0,8 % d'hydroquinone et 60,2 % de silice à l'état de particules discrètes, monodisperses, d'un diamètre moyen de 13 nm, non liées entre elles par des liaisons siloxane et présentant à 20°C, une densité de 1,576 et une viscosité Brookfield de 2200 mPa.s à 780 tours par minute.

## EXEMPLE 2

On prépare comme précédemment un hydrosol acide de silice, présentant un pH = 2,1 et contenant pondéralement 50 % d'eau et 50 % de silice à l'état de particules discrètes, monodisperses, d'un diamètre moyen de 50 nm, non liées entre elles par des liaisons siloxane, à partir d'un hydrosol de silice commercial stabilisé, présentant un pH de 9,3 et contenant pondéralement 50 % d'eau, 0,3 % de $Na_2O$ et 49,7 % de silice à l'état de particules monodisperses, d'un diamètre moyen de 50 nm, non liées entre elles par des liaisons siloxane.

On mélange ensuite sous agitation et à la température ambiante, 2808,3 g de cet hydrosol acide de silice avec 611,4 g d'acrylate d'hydroxy-2 éthyle et 16,6 g d'hydroquinone. Puis l'eau présente dans le milieu réactionnel est éliminée par distillation, sous agitation, à une température inférieure à 55 °C, sous une pression réduite progressivement de 60 à 20 mbar. On obtient ainsi 2035 g d'une dispersion silico-acrylique contenant pondéralement 30,3 % d'acrylate d'hydroxy-2 éthyle, 0,8 % d'hydroquinone, 0,7 % d'eau et 68,2 % de silice à l'état de particules discrètes, monodisperses, d'un diamètre moyen de 50 nm, non liées entre elles par des liaisons siloxane, et présentant une viscosité Brookfield, déterminée à 20°C, sous 780 tours par minute de 8000 mPa.s.

Cette dispersion silico-acrylique est ensuite diluée avec 100 g d'acrylate d'hydroxy-2 éthyle pour amener son titre en silice à 65 % en poids. On obtient ainsi une dispersion silico-acrylique présentant, à 20°C, une densité de 1,635 et une viscosité Brookfield de 740 mPa.s, sous 780 tours par minute et contenant pondéralement 33,5 % d'acrylate d'hydroxy-2 éthyle, 0,7 % d'eau, 0,8 % d'hydroquinone et 65 % de silice à l'état de particules monodisperses d'un diamètre moyen de 50 nm, non liées entre elles par des liaisons siloxane.

## EXEMPLE 3

On mélange sous agitation, à la température ambiante, 500 g de la dispersion silico-acrylique obtenue à l'exemple 1 et 500 g de la dispersion silico-acrylique obtenue à l'exemple 2. On obtient ainsi 1000 g d'une dispersion silico-acrylique contenant pondéralement 36 % d'acrylate d'hydroxy-2 éthyle, 0,7 % d'eau, 0,7 % d'hydroquinone et 62,5 % de silice à l'état de particules discrètes, polydisperses, non liées entre elles par des liaisons siloxane dont 48 % d'entre elles en poids, présentent un diamètre moyen de 13 nm et 52 % un diamètre moyen de 50 nm. Cette dispersion présente une densité de 1,605.

## EXEMPLE 4

On mélange sous agitation, à la température ambiante, 666,7 g de l'hydrosol acide de silice préparé à l'exemple 1 avec 200 g d'un mélange de monoester de l'acide acrylique avec le propanediol-1,2 contenant 75 % d'acrylate d'hydroxy-2 propyle, 25 % d'acrylate d'hydroxy-2 méthyl-1 éthyle et 33,4 g d'hydroquinone. Puis, l'eau présente dans ce milieu réactionnel est distillée, sous agitation, à une température inférieure à 55°C, sous une pression réduite progressivement de 60 à 20 mbar. On obtient ainsi 400 g d'une dispersion silico-acrylique contenant pondéralement 48 % de monoesters de l'acide acrylique avec le propanediol-1,2, 0,8 % d'hydroquinone, 0,8 % d'eau et 50 % de silice à l'état de particules monodisperses, d'un diamètre moyen de 13 nm, non liées entre elles par des liaisons siloxane et présentant à 20 °C, une densité de 1,446 et une viscosité Brookfield, à 780 tours par minute, de 1528 mPa.s.

## EXEMPLE 5

Dans la dispersion préparée à l'exemple 3, on introduit à la température ambiante, sous agitation, 1 % en poids de benzophénone et 1 % en poids d'hydroxy-1 cyclohexylphénylcétone, puis avec ce mélange, on prépare sur une machine de stéréophotolithographie équipée d'une source laser à argon ionisé fonctionnant dans l'ultraviolet (351 et 363 nm) un cube alvéolé de 30 mm d'arête contenant 36 alvéoles parallélépipèdiques, avec une grille de maille de 5 mm, avec une vitesse de déplacement du faisceau laser de 2,4 cm/s, une puissance de 400 mW et une épaisseur de couche de 0,25 mm. On obtient ainsi avant la post-polymérisation, un objet transparent, d'excellente présentation, avec des parois épaisses, régulières et bien définies. Après une post-polymérisation de 90 minutes dans une étuve à 150 °C, le cube alvéolé est totalement dur et il ne présente ni fissure, ni trace de silice en surface. Le retrait volumique est de 4 % (dp = 1,666).

## EXEMPLES 6 ET 7

On prépare un cube alvéolé, comme dans l'exemple 5, avec les dispersions préparées dans les exemples 1 et 2 dans lesquelles on a introduit 1 % en poids de benzophénone et 1 % en poids d'hydroxy-1 cyclohexylphénylcétone. On obtient ainsi deux cubes alvéolés de présentation correcte, avec des parois transparentes et bien définies. Le retrait volumique est de 6 % pour la dispersion de l'exemple 1 et de 1,5 % pour la dispersion de l'exemple 2.

## EXEMPLE DE COMPARAISON N°1

Dans une dispersion commerciale de silice dans l'acrylate d'hydroxy-2 éthyle contenant pondéralement 69,2 % d'acrylate d'hydroxy-2 éthyle, 0,8 % d'eau et 30 % de silice à l'état de particules discrètes, monodisperses, d'un diamètre moyen de 13 nm, présentant une densité de 1,259, on prépare comme dans l'exemple 5 un cube alvéolé après introduction dans la dispersion de 1 % en poids de benzophénone et de 1 % en poids d'hydroxy-1 cyclohexylphénylcétone.

On obtient ainsi un cube de très mauvaise présentation avec des parois boursouflées et une mauvaise adhérence entre les couches. Le retrait volumique de cette dispersion est de 15 %.

## Revendications

1. Dispersions de silice colloïdale dans un acrylate d'alcanol ou un mélange d'acrylates d'alcanols de formule générale (I)

$$CH_2 = CH - COO - CHR - CHOH - R_1 \qquad (I)$$

dans laquelle soit R et $R_1$, identiques, représentent un atome d'hydrogène, soit R et $R_1$, différents,

représentent un atome d'hydrogène ou un radical méthyle, caractérisées par le fait qu'elles contiennent pondéralement de 50 à 70% de silice à l'état de particules discrètes, appartenant à au moins deux groupes de silice monodisperse, non liées entre elles par des liaisons siloxane d'un diamètre moyen compris entre 10 et 50 nm.

2. Dispersions selon la revendication 1, caractérisées par le fait que 20 à 50 % en poids de la silice présente est sous forme de particules discrètes d'un diamètre moyen identique, inférieur ou égal à la moitié du diamètre moyen d'au moins 50 % en poids des particules de silice restantes.

3. Dispersions selon la revendication 2, caractérisées par le fait qu'elles contiennent pondéralement dans l'acrylate d'hydroxy-2 éthyle de 50 à 70 % de silice à l'état de particules discrètes non liées entre elles par des liaisons siloxane, présentant pour 40 à 50 % en poids d'entre elles, un diamètre moyen d'environ 13 nm, et pour le complément à 100 %, un diamètre moyen d'environ 50 nm.

4. Procédé de préparation des dispersions selon l'une quelconque des revendications 1 à 3, caractérisé par le fait que l'on mélange, sous agitation, à la température ambiante, un hydrosol de silice, monodisperse, sous forme acide, contenant pondéralement 30 à 50 % de silice à l'état de particules discrètes non liées entre elles par des liaisons siloxane, d'un diamètre moyen de 10 à 50 nm avec une quantité calculée d'un acrylate d'alcanol, ou d'un mélange d'acrylates d'alcanols de formule générale (I)

$$CH_2 = CH - COO - CHR - CHOH - R_1 \qquad (I)$$

dans laquelle soit R et $R_1$, identiques, représentent un atome d'hydrogène, soit R et $R_1$, différents, représentent, un atome d'hydrogène ou un radical méthyle, de manière à obtenir le taux de silice désiré compris entre 50 et 70 % en poids, puis que l'on distille l'eau présente dans cette dispersion, sous agitation, à une température inférieure à 55 °C, et sous pression réduite, jusqu'à un taux d'eau résiduelle inférieur à 1 % en poids, déterminé par la méthode de Karl Fischer, pour obtenir une dispersion monodisperse de silice colloïdale dans l'acrylate d'alcanol ou le mélange d'acrylates d'alcanols de formule générale (I) choisi, contenant de 50 à 70 % en poids de silice sous forme de particules discrètes non liées entre elles par des liaisons siloxane, présentant un diamètre moyen de 10 à 50 nm que l'on mélange, à la température ambiante, dans des proportions convenables, avec une ou plusieurs autres dispersions monodisperses de silice colloïdale de granulométrie souhaitée et de taux en silice adéquat, dans un acrylate d'alcanol ou un mélange d'acrylates d'alcanols de formule générale (I) identique et préparées selon le procédé décrit ci-dessus, de manière à obtenir la dispersion silico-acrylique polydisperse souhaitée.

5. Procédé selon la revendication 4, caractérisé par le fait que l'on prépare une dispersion monodisperse de particules de silice colloïdale d'un certain diamètre que l'on mélange avec au moins une dispersion monodisperse de particules de silice colloïdale d'un diamètre moyen inférieur ou égal à la moitié du diamètre moyen des premières particules de silice, les dernières particules de silice représentant 20 à 50 % en poids de la silice présente, tandis que les premières particules de silice représentent au moins 50 % des particules de silice restantes.

6. Procédé selon la revendication 4 ou 5, caractérisé par le fait que 40 à 50 % en poids des particules de silice ont un diamètre moyen d'environ 13 nm, et le complément à 100 % a un diamètre moyen d'environ 50 nm.

7. Utilisation en stéréophotolithographie, à titre de résine, d'une dispersion selon la revendication 1.

8. Utilisation en stéréophotolithographie, à titre de résine, d'une dispersion selon l'une quelconque des revendications 2 et 3.

9. Utilisation en stéréophotolithographie, à titre de résine, d'une dispersion selon l'une quelconque des revendications 1 à 3, obtenue par le procédé de l'une quelconque des revendications 4 à 6.

10. Procédé de préparation d'objets en résine photosensible, caractérisé par le fait que l'on utilise dans le procédé conventionnel une dispersion de silice colloïdale selon l'une des revendications 1 à 3 ou obtenue selon le procédé d'une quelconque des revendications 4 à 6.

**Claims**

1. Dispersions of colloidal silica in an alkanol acrylate or a mixture of alkanol acrylates, of formula (I):

$$CH_2 = CH - COO - CHR - CHOH - R_1 \qquad (I)$$

in which either R and $R_1$ are identical and represent a hydrogen atom or R and $R_1$ are different and represent a hydrogen atom or a methyl radical, characterized by the fact that they contain 50 to 70% by weight of silica in the form of discrete particles, belonging to at least two groups of monodispersed silica, not linked together by siloxane bonds and of an average diameter between 10 and 50 nm.

2. Dispersions according to claim 1, characterized by the fact that 20 to 50% by weight of the silica present is in the form of discrete particles of an identical average diameter, less than or equal to half of the average diameter of at least 50% by weight of the remaining silica particles.

3. Dispersions according to claim 2, characterized by the fact that they contain by weight in 2-hydroxy acrylate from 50 to 70% of silica in the form of discrete particles not linked together by siloxane bonds, having an average diameter of about 13 nm for 40 to 50% by weight of them, and an average diameter of about 50 nm for the complement to 100%.

4. Preparation process for the dispersions according to any one of claims 1 to 3, characterized by the fact that a monodispersed silica hydrosol, in acid form, containing 30 to 50% by weight of silica in the form of discrete particles not linked together by siloxane bonds, of an average diameter of 10 to 50 nm, is mixed under agitation at ambient temperature with a calculated quantity of an alkanol acrylate or a mixture of alkanol acrylates of formula (I)

$$CH_2 = CH - COO - CHR - CHOH - R_1 \qquad (I)$$

in which either R and $R_1$ are identical and represent a hydrogen atom or R and $R_1$ are different and represent a hydrogen atom or a methyl radical, in a manner so as to obtain the desired proportion of silica which is comprised between 50 to 70% by weight, then the water present in this dispersion is distilled off at a temperature below 55°C, under reduced pressure and under agitation, until the residual water content is below 1% by weight, as determined by the Karl Fisher method, in order to obtain a monodispersed dispersion of colloidal silica in the alkanol acrylate or the chosen mixture of alkanol acrylates of formula (I), containing 50 to 70% by weight of silica in the form of discrete particles not linked together by siloxane bonds, having an average diameter of 10 to 50 nm which is mixed, at ambient temperature, in suitable proportions with one or more other monodispersed dispersions of colloidal silica of desired granulometry and adequate silica content, in an alkanol acrylate or a mixture of alkanol acrylates of identical formula (I) and prepared according to the process described above, in a manner so as to obtain the desired polydispersed silico-acrylic dispersion.

5. Process according to claim 4, characterized by the fact that a monodispersed dispersion of colloidal silica particles of a certain diameter is prepared which is mixed with at least one monodispersed dispersion of colloidal silica particles of an average diameter less than or equal to half the average diameter of the first silica particles, the latter silica particles representing 20 to 50% by weight of the silica present, whilst the first silica particles represent at least 50% of the remaining silica particles.

6. Process according to claim 4 or 5, characterized by the fact that 40 to 50% by weight of the silica particles have an average diameter of about 13 nm and the complement to 100% have an average diameter of about 50 nm.

7. The use in stereophotolithography, as a resin, of a dispersion according to claim 1.

8. The use in stereophotolithography, as a resin, of a dispersion according to any one of claims 2 to 3.

9. The use in stereophotolithography, as a resin, of a dispersion according to any one of claims 1 to 3, obtained by the process of any one of claims 4 to 6.

10. Preparation process for objects in photosensitive resin, characterized by the fact that a colloidal silica dispersion according to any one of claims 1 to 3 or obtained according to the process of any one of claims 4 to 6 is used in the conventional process.

**Patentansprüche**

1. Dispersionen von kollodialer Kieselsäure in einem Alkanolacrylat oder einer Mischung von Alkanolacrylaten der allgemeinen Formel (I)

$$CH_2 = CH - COO - CHR - CHOH - R_1 \qquad (I)$$

worin R und $R_1$ entweder gleich sind und für ein Wasserstoffatom stehen, oder R und $R_1$ verschieden sind und für ein Wasserstoffatom oder einen Methylrest stehen, dadurch gekennzeichnet, daß sie 50 bis 70 Gew.-% Kieselsäure in Form isolierter Teilchen eines mittleren Durchmessers zwischen 10 und 50 nm enthalten, welche mindestens zwei Gruppen monodisperser Kieselsäure angehören und untereinander nicht über Siloxanbrücken verbunden sind.

2. Dispersionen nach Anspruch 1, dadurch gekennzeichnet, daß 20 bis 50 Gew.-% der vorhandenen Kieselsäure in Form isolierter Teilchen eines einheitlichen mittleren Durchmessers vorliegen, der kleiner oder gleich dem halben mittleren Durchmesser von mindestens 50 Gew.-% der restlichen Kieselsäureteilchen ist.

3. Dispersionen nach Anspruch 2, dadurch gekennzeichnet, daß diese in 2-Hydroxyethylacrylat 50 bis 70 Gew.-% Kieselsäure in Form isolierter Teilchen enthalten, die untereinander nicht über Siloxanbrücken verbunden sind, von denen 40 bis 50 Gew.-% einen mittleren Durchmesser von etwa 13 nm und der Rest auf 100% einen mittleren Durchmesser von etwa 50 nm aufweist.

4. Verfahren zur Herstellung der Dispersionen nach einem der Ansprüche 1 bis 3, dadurch gekennzeichnet, daß man unter Bewegung bei Umgebungstemperatur ein monodisperses Kieselsäurehydrosol in Säureform, enthaltend 30 bis 50 Gew.-% Kieselsäure in Form isolierter Teilchen eines mittleren Durchmessers von 10 bis 50 nm, die untereinander nicht über Siloxanbrücken verbunden sind, mit einer berechneten Menge eines Alkanolacrylats oder einer Mischung von Alkanolacrylaten der allgemeinen Formel (I)

$$CH_2 = CH - COO - CHR - CHOH - R_1 \qquad (I)$$

worin R und $R_1$ entweder gleich sind und für ein Wasserstoffatom stehen, oder R und $R_1$ verschieden sind und für ein Wasserstoffatom oder einen Methylrest stehen, derart mischt, daß der gewünschte Gehalt an Kieselsäure im Bereich von 50 bis 70 Gew.-% erhalten wird, dann unter Bewegung bei einer Temperatur von weniger als 55°C und unter vermindertem Druck das in dieser Dispersion vorhandene Wasser abdestilliert, bis der Restwassergehalt, bestimmt nach dem Karl Fischer-Verfahren, weniger als 1 Gew.-% beträgt, um eine monodisperse kolloidale Dispersion von Kieselsäure in dem gewählten Alkanolacrylat oder der Mischung der Alkanolacrylate der allgemeinen Formel (I) zu erhalten, die 50 bis 70 Gew.-% Kieselsäure in Form isolierter Teilchen enthält, die untereinander nicht über Siloxanbrücken verbunden sind und einen mittleren Durchmesser von 10 bis 50 nm aufweisen, die man bei Umgebungstemperatur in geeigneten Verhältnissen mit einer oder mehreren anderen gemäß dem vorstehend beschriebenen Verfahren hergestellten monodispersen Dispersionen von kolloidaler Kieselsäure in einem Alkanolacrylat oder einer Mischung von Alkanolacrylaten der gleichen allgemeinen Formel (I) mit der gewünschten Granulometrie und dem entsprechenden Gehalt an Kieselsäure derart mischt, daß die gewünschte polydisperse Silico-Acryldispersion erhalten wird.

5. Verfahren nach Anspruch 4, dadurch gekennzeichnet, daß man eine monodisperse Dispersion von Teilchen kolloidaler Kieselsäure eines bestimmten Durchmessers herstellt, die man mit mindestens einer monodispersen Dispersion von Teilchen kolloidaler Kieselsäure eines mittleren Durchmessers von weniger als oder gleich dem halben mittleren Durchmesser der ersteren Kieselsäureteilchen mischt, wobei letztere Kieselsäureteilchen 20 bis 50 Gew.-% der vorliegenden Kieselsäure ausmachen, während die ersteren Kieselsäureteilchen mindestens 50% der restlichen Kieselsäureteilchen ausmachen.

6. Verfahren nach Anspruch 4 oder 5, dadurch gekennzeichnet, daß 40 bis 50 Gew.-% der Kieselsäureteilchen einen mittleren Durchmesser von etwa 13 nm und der Rest auf 100% einen mittleren Durchmesser von etwa 50 nm aufweist.

7. Verwendung einer Dispersion nach Anspruch 1 in der Stereophotolithographie auf der Grundlage von Harzen.

8. Verwendung einer Dispersion nach einem der Ansprüche 2 und 3 in der Stereophotolithographie auf der Grundlage von Harzen.

9. Verwendung einer Dispersion nach einem der Ansprüche 1 bis 3, die nach dem Verfahren nach einem der Ansprüche 4 bis 6 erhalten ist, in der Stereophotolithographie auf der Grundlage von Harzen.

10. Verfahren zur Herstellung von Gegenständen aus photosensiblem Harz, dadurch gekennzeichnet, daß man in einem herkömmlichen Verfahren eine Dispersion kolloidaler Kieselsäure nach einem der Ansprüche 1 bis 3 oder eine solche, die nach dem Verfahren nach einem der Ansprüche 4 bis 6 erhalten ist, verwendet.